# EUROPEAN PATENT APPLICATION

(11) **EP 3 361 186 A1**
(43) Date of publication of application: **15.08.2018**
(21) Application number: 16889945.8
(22) Date of filing: 13.12.2016
(51) Int. Cl.: F25B 1/00, F24F 1/24, H05K 7/20

(54) **REFRIGERATION CYCLE DEVICE**

(30) Priority: 08.02.2016 JP 2016022038
(71) Applicant: Mitsubishi Heavy Industries Thermal Systems, Ltd., Minato-ku, Tokyo 108-8215 (JP)
(72) Inventor: MITOMA, Keisuke, Tokyo 108-8215 (JP); YOSHIDA, Junichi, Tokyo 108-8215 (JP); ISOZUMI, Shinichi, Tokyo 108-8215 (JP); KURACHI, Masaya, Tokyo 108-8215 (JP)
(74) Representative: Henkel, Breuer & Partner
(86) International application number: PCT/JP2016/087076
(87) International publication number: WO 2017/138244

(57) **Abstract**

A refrigeration cycle device equipped with: a power element (83A) provided on a substrate (83B); a control box (81) to which the substrate (83B) is attached; a cooling jacket (87) that is provided outside the control box (81) and cools the power element (83A) using coolant that flows therethrough; a bracket (93) to which the cooling jacket (87) is attached; and a base (85) for independently securing the control box (81) and the bracket (93). As a result, it is possible to further reduce the effect of a load on the power element (83A).

## Description

### Technical Field

The present invention relates to a refrigeration cycle device.

### Background Art

In an air conditioner in which refrigerant circulates to perform a vapor compression refrigeration cycle, electrical circuits such as inverter circuits are mounted in order to control an operating state of an electric motor of a compressor. For such an inverter circuit, a power device generating high-temperature heat has been generally used. And in a known air conditioner, a unit configured to cool the power device is provided so as to prevent a temperature of the power device from exceeding a temperature at which the power device is operable.

In the related arts, Patent Document 1, for example, an air conditioner is described, which includes a printed circuit board to which a power device is attached, a refrigerant jacket through which refrigerant used for a refrigeration cycle flows, and a switch box to which the printed circuit board is fixed via a spacer. In the air conditioner, the refrigerant flowing through the refrigerant jacket cools the power device. In the air conditioner, the power device is attached to the refrigerant jacket through a heat transfer plate, and the heat transfer plate is attached to the switch box.

### Prior Art Documents

### Patent Document

Patent Document 1: JP 4488093 B

### Summary of the Invention

### Problem to be Solved by the Invention

The air conditioner disclosed in Patent Document 1 is described therein that a refrigerant jacket is indirectly fixed to a switch box through a heat transfer plate, and the printed circuit board and the refrigerant jacket are connected by the switch box. When the refrigerant jacket is excited by vibration transferred through a refrigerant pipe, for example, the printed circuit board and the refrigerant jacket move (vibrate) in a similar manner.

However, the refrigerant jacket, the heat transfer plate, the printed circuit board, and the power device are all secured to the switch box. This causes the switch box to absorb the vibration when the refrigerant jacket is exited. As a result, the vibration is transferred to all of the components including the power device. Therefore, further reducing an act of a load on the power device is preferred.

The present invention solves the above-described problem and has an object of providing a refrigeration cycle device capable of further reducing an act of a load on a power device.

### Means for Solving the Problem

In order to achieve the above-described object, a refrigeration cycle device according to a first aspect of the present invention includes a power device provided on a circuit board, a control box to which the circuit board is attached, a refrigerant jacket that is provided outside the control box and cools the power device by using refrigerant that flows inside the refrigerant jacket, a bracket to which the refrigerant jacket is attached, and a base that independently secures the control box and the bracket.

In the refrigeration cycle device, the refrigerant jacket that cools the power device is secured to the base via the bracket, independently from the control box to which the power device is attached via the circuit board. Therefore, when the refrigerant flows and the refrigerant jacket is thus exited due to vibration transferred, the vibration of the refrigerant jacket is absorbed by the bracket independently from the control box. This reduces the transfer of the vibration to the power device, thereby further reducing an act of a load on the power device.

A refrigeration cycle device according to a second aspect of the present invention is the refrigeration cycle device according to the first aspect of the present invention, in which the circuit board is detachably provided on the control box side together with the refrigerant jacket, and is supported on the control box side.

In the refrigeration cycle device, the circuit board and the refrigerant jacket are supported on the control box side, whereby the refrigerant jacket can be assembled in an integrated manner with the control box. When assembling, for example, the refrigerant piping inside which the refrigerant flows is not yet connected to any other place in the refrigeration cycle device. Therefore, assembling the refrigerant jacket in an integrated manner with the control box increases the assemblability.

A refrigeration cycle device according to a third aspect of the present invention is the refrigeration cycle device according to the first aspect of the present invention, in which the circuit board is detachably provided on the bracket side together with the refrigerant jacket, and is supported on the bracket side.

In the refrigeration cycle device, the circuit board and the refrigerant jacket are supported on the bracket side, whereby the control box can be removed while leaving the circuit board and the power device together with the refrigerant jacket on the bracket side. When disassembling for maintenance, for example, the refrigerant piping inside which the refrigerant flows has been connected to any other place in the refrigeration cycle device. Therefore, removing the control box while leaving and without removing the refrigerant jacket, the circuit board, and the power device cooled by the refrigerant jacket increases the maintainability.

A refrigeration cycle device according to a fourth aspect of the present invention is the refrigeration cycle device according to the first aspect of the present invention, in which the refrigerant jacket and the power device are attached to each other via a heat transfer plate.

In the refrigeration cycle device, the refrigerant jacket and the power device are attached via the heat transfer plate. Therefore, when the refrigerant flows and the refrigerant jacket is thus exited due to vibration transferred, the vibration of the refrigerant jacket is absorbed by the heat transfer plate. This further reduces the transfer of the vibration to the power device, thereby further reducing an act of a load on the power device.

A refrigeration cycle device according to a fifth aspect of the present invention is the refrigeration cycle device according to the fourth aspect of the present invention, in which the circuit board is attached to the control box via the heat transfer plate.

In the refrigeration cycle device, the circuit board is attached to the heat transfer plate. Therefore, when the refrigerant flows and the refrigerant jacket is thus exited due to vibration transferred, the vibration of the refrigerant jacket is absorbed by the heat transfer plate and transferred to not only the power device but also the circuit board. As a result, an identical vibration is transferred to the power device and the circuit board, thereby preventing the connection between the power device and the circuit board from being disconnected.

A refrigeration cycle device according to a sixth aspect of the present invention is the refrigeration cycle device according to the fourth or fifth aspect of the present invention, in which the circuit board is detachably provided on the control box side together with the refrigerant jacket via the heat transfer plate, and is supported on the control box side.

In the refrigeration cycle device, the circuit board, the heat transfer plate, and the refrigerant jacket are supported on the control box side, whereby the refrigerant jacket can be assembled in an integrated manner with the control box. When assembling, for example, the refrigerant piping inside which the refrigerant flows is not yet connected to any other place in the refrigeration cycle device. Therefore, assembling the refrigerant jacket in an integrated manner with the control box increases the assemblability.

A refrigeration cycle device according to a seventh aspect of the present invention is the refrigeration cycle device according to the fourth or fifth aspect of the present invention, in which the circuit board is detachably provided on the bracket side together with the refrigerant jacket via the heat transfer plate, and is supported on the bracket side.

In the refrigeration cycle device, the circuit board, the heat transfer plate, and the refrigerant jacket are supported on the bracket side, whereby the control box can be removed while leaving the circuit board and the power device together with the refrigerant jacket on the bracket side. When disassembling for maintenance, for example, the refrigerant piping inside which the refrigerant flows has been connected to any other place in the refrigeration cycle device. Therefore, removing the control box while leaving the circuit board and the power device cooled by the refrigerant jacket without removing the refrigerant jacket increases the maintainability.

### Effect of Invention

According to the present invention, the act of a load on the power device can be further reduced.

### Brief Description of the Drawings

FIG. 1 is a refrigerant circuit diagram of a refrigeration cycle device according to an embodiment of the present invention.
FIG. 2 is an enlarged view of a cooling device of a refrigeration cycle device according to a first embodiment of the present invention.
FIG. 3 is an enlarged view of the cooling device of the refrigeration cycle device according to the first embodiment of the present invention.
FIG. 4 is an enlarged view of the cooling device of the refrigeration cycle device according to the first embodiment of the present invention.
FIG. 5 is an enlarged view of the cooling device of the refrigeration cycle device according to the first embodiment of the present invention.
FIG. 6 is an enlarged view of the cooling device of the refrigeration cycle device according to the first embodiment of the present invention.
FIG. 7 is an enlarged view of a cooling device of a refrigeration cycle device according to a second embodiment of the present invention.
FIG. 8 is an enlarged view of the cooling device of the refrigeration cycle device according to the second embodiment of the present invention.
FIG. 9 is an enlarged view of the cooling device of the refrigeration cycle device according to the second embodiment of the present invention.
FIG. 10 is an enlarged view of a cooling device of a refrigeration cycle device according to a third embodiment of the present invention.
FIG. 11 is an enlarged view of the cooling device of the refrigeration cycle device according to the third embodiment of the present invention.
FIG. 12 is an enlarged view of the cooling device of the refrigeration cycle device according to the third embodiment of the present invention.
FIG. 13 is an enlarged view of the cooling device of the refrigeration cycle device according to the third embodiment of the present invention.
FIG. 14 is an enlarged view of the cooling device of the refrigeration cycle device according to the third embodiment of the present invention.
FIG. 15 is another example refrigerant circuit diagram of a refrigeration cycle device according to an embodiment of the present invention.

### Description of the Preferred Embodiments

Embodiments according to the present invention will be described below on the basis of the drawings. Note that the present invention is not limited by these embodiments. In addition, the constituent elements in the embodiments described below include those that can be easily replaced by a person skilled in the art or those that are substantially the same.

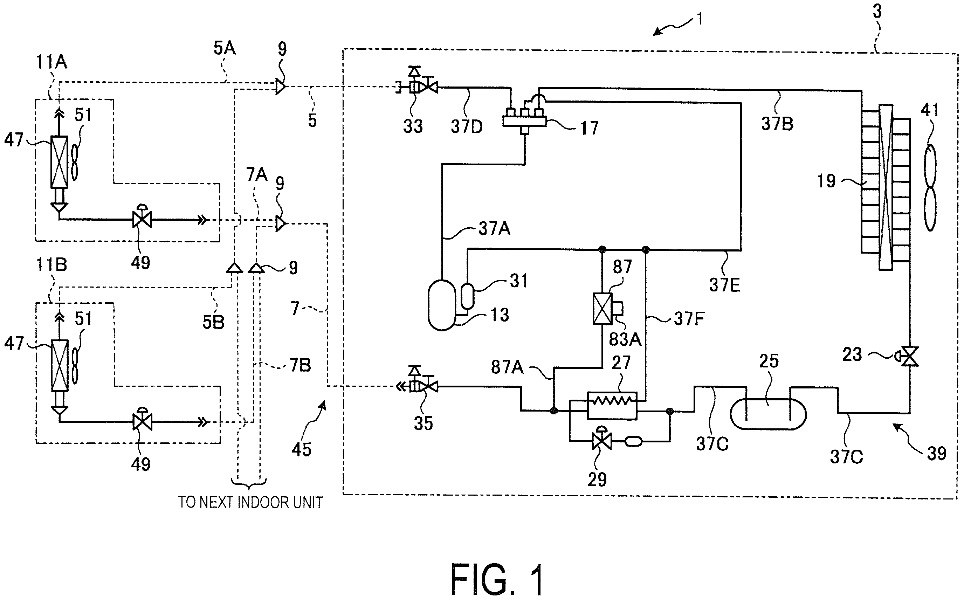

FIG. 1 is a refrigerant circuit diagram of a refrigeration cycle device according to the present embodiment.

FIG. 1 illustrates a multiple-type air conditioner 1 as an example to which the refrigeration cycle device is applied. The refrigeration cycle device can be applied to a heat pump, which is not illustrated in the drawing. The multiple-type air conditioner 1 includes a single outdoor unit 3, gas-side piping 5 and liquid-side piping 7 that are led from the outdoor unit 3, and a plurality of indoor units 11A and 11B connected in parallel via branching devices 9 between the gas-side piping 5 and the liquid-side piping 7.

The outdoor unit 3 includes a compressor 13 driven by an inverter that compresses refrigerant, a four-way selector valve 17 that selects a circulation direction of the refrigerant, an outdoor heat exchanger 19 that causes the refrigerant and outside air to exchange heat, an outdoor electronic expansion valve for heating (EEVH) 23, a receiver 25 that stores liquid refrigerant, a subcooling heat exchanger 27 that applies subcooling to the liquid refrigerant, an electronic expansion valve for subcooling (EEVSC) 29 that controls a refrigerant amount to be branched to the subcooling heat exchanger 27, an accumulator 31 that separates a liquid portion from refrigerant gas to be suctioned into the compressor 13 and allows only a gas portion to be suctioned by the compressor 13, a gas-side operation valve 33, and a liquid-side operation valve 35.

Each of the above-described devices on the outdoor unit 3 side is connected as in the related art via refrigerant piping, such as discharge piping 37A, gas piping 37B, liquid piping 37C, gas piping 37D, intake piping 37E, and branching piping for subcooling 37F for subcooling, and thus configures an outdoor refrigerant circuit 39. Further, an outdoor fan 41 that blows outside air to the outdoor heat exchanger 19 is provided to the outdoor unit 3.

The gas-side piping 5 and the liquid-side piping 7 are refrigerant piping connected to the gas-side operation valve 33 and the liquid-side operation valve 35 of the outdoor unit 3. The lengths of the gas-side piping 5 and the liquid-side piping 7 are set as appropriate in accordance with a distance between the outdoor unit 3 and each of the indoor units 11A and 11B connected to the outdoor unit 3 during onsite installation work. An appropriate number of the branching devices 9 are disposed midway on the gas-side piping 5 and the liquid-side piping 7, and an appropriate number of the indoor units 11A and 11B are each connected via the branching devices 9. As a result, a refrigeration cycle 45 of one hermetically sealed system is configured.

The indoor units 11A and 11B each include an indoor heat exchanger 47 that causes the refrigerant and inside air to exchange heat and thus performs indoor air conditioning, an indoor electronic expansion valve for cooling (EEVC) 49, and an indoor fan 51 that circulates the inside air via the indoor heat exchanger 47. The indoor units 11A and 11B are connected to the branching devices 9 via branched gas-side piping 5A and 5B and branched liquid-side piping 7A and 7B on the indoor side.

In the above-described multiple-type air conditioner 1, the heating operation is performed as follows. The high-temperature, high-pressure refrigerant gas that has been compressed by the compressor 13 is discharged to the discharge piping 37A. The refrigerant is then circulated to the gas piping 37D side by the four-way selector valve 17. This refrigerant is led out from the outdoor unit 3 via the gas-side operation valve 33 and the gas-side piping 5, and is further introduced into the indoor units 11A and 11B via the branching devices 9 and the branched gas-side piping 5A and 5B on the indoor side.

The high-temperature, high-pressure refrigerant gas introduced into the indoor units 11A and 11B is subjected to heat exchange with the inside air circulated by the indoor fan 51. The inside air is thus heated and provided for indoor heating. The refrigerant is condensed and reaches the branching device 9 via the indoor electronic expansion valve (EEVC) 49 and the branched liquid-side piping 7A and 7B. Then, the refrigerant is merged with the refrigerant from other indoor units, and is subsequently returned to the outdoor unit 3 via the liquid-side piping 7.

The refrigerant that has returned to the outdoor unit 3 reaches the subcooling heat exchanger 27 via the liquid-side operation valve 35 and the liquid piping 37C. The refrigerant is subjected to subcooling in the same manner as during cooling, and then introduced into the receiver 25, where the circulation amount of the refrigerant is adjusted by being temporarily stored. This liquid refrigerant is supplied to the outdoor electronic expansion valve (EEVH) 23 via the liquid piping 37C. The liquid refrigerant is then adiabatically expanded, and subsequently introduced into the outdoor heat exchanger 19.

In the outdoor heat exchanger 19, heat is exchanged between the refrigerant and the outside air blown from the outdoor fan 41, and the refrigerant absorbs the heat from the outside air and is evaporated and gasified. This refrigerant passes through the gas piping 37B, the four-way selector valve 17, and the intake piping 37E from the outdoor heat exchanger 19. This refrigerant is then merged with the refrigerant from the branching piping for subcooling 37F and is subsequently introduced into the accumulator 31. In the accumulator 31, the liquid portion contained in the refrigerant gas is separated, and only the gas portion is suctioned into the compressor 13 and once again compressed in the compressor 13. The heating operation is performed by repeating the cycle described above.

On the other hand, the cooling operation is performed as follows. The high-temperature, high-pressure refrigerant gas that has been compressed in the compressor 13 is discharged to the discharge piping 37A. Subsequently, the refrigerant gas is circulated toward the gas piping 37B side by the four-way selector valve 17. The refrigerant gas is then subjected to heat exchange with the outside air blown by the outdoor fan 41 to be condensed and liquefied in the outdoor heat exchanger 19. This liquid refrigerant passes through the outdoor electronic expansion valve 23 and temporarily stored in the receiver 25.

The liquid refrigerant for which the circulation amount has been adjusted by the receiver 25 is partially diverted into the branching piping for subcooling 37F in the process of flowing through the subcooling heat exchanger 27 via the liquid piping 37C. The liquid refrigerant is then subjected to heat exchange with the refrigerant adiabatically expanded by the electronic expansion valve for subcooling (EEVSC) 29, thereby imparting the degree of subcooling to the liquid refrigerant. This liquid refrigerant is introduced from the outdoor unit 3 to the liquid-side piping 7 via the liquid-side operation valve 35. The liquid refrigerant introduced to the liquid-side piping 7 is further diverted to the branched liquid-side piping 7A and 7B of each of the indoor units 11A and 11B via the branching devices 9.

The liquid refrigerant diverted to the branched liquid-side piping 7A and 7B flows into each of the indoor units 11A and 11B. The liquid refrigerant is adiabatically expanded by the indoor electronic expansion valve (EEVC) 49 to form a gas-liquid two-phase flow, and is then introduced into the indoor heat exchanger 47. In the indoor heat exchanger 47, the refrigerant that has turned to a gas-liquid two-phase flow is subject to heat exchange with the inside air circulated by the indoor fan 51. The inside air is thus cooled and provided for indoor cooling. On the other hand, the refrigerant is gasified and flows to the branching device 9 via the branched gas-side piping 5A and 5B. The refrigerant is merged with the refrigerant gas from other indoor units in the gas-side piping 5.

The refrigerant gas merged in the gas-side piping 5 is returned once again to the outdoor unit 3 side and reaches the intake piping 37E via the gas-side operation valve 33, the gas piping 37D, and the four-way selector valve 17. The refrigerant gas is then merged with the refrigerant gas from the branching piping for subcooling 37F. The merged gas is subsequently introduced into the accumulator 31. In the accumulator 31, the liquid portion contained in the refrigerant gas is separated, and only the gas portion is suctioned into the compressor 13. This refrigerant is once again compressed in the compressor 13. The cooling operation is performed by repeating the cycle described above. In the above-described manner, the refrigerant circuit is configured to circulate the refrigerant in the multiple-type air conditioner 1 as a refrigeration cycle device includes.

In such a refrigeration cycle device, an electrical circuit such as an inverter circuit is provided to control an operation of the compressor 13. The electrical circuit is cooled by the cooling device. The following describes some embodiments of a cooling device that cools an electrical circuit.

### First Embodiment

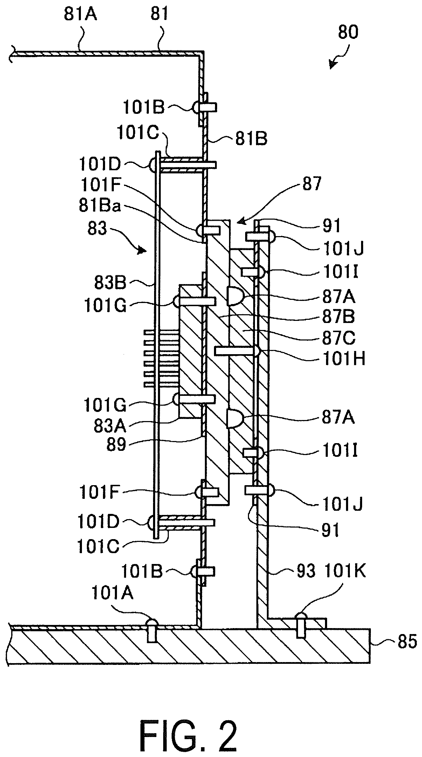

FIGS. 2 to 6 are enlarged views of a refrigeration cycle device according to the present embodiment.

As illustrated in FIG. 2, the cooling device 80 includes a control box 81 as a housing in which an electrical circuit 83 and other components are accommodated. The control box 81 includes a box main body 81A and a segment 81B. The box main body 81A is a housing member in which the electrical circuit 83 and other components are accommodated. The box main body 81A is detachably attached with a screw 101A to a base 85 that supports some of the above-described components of the outdoor unit 3. The segment 81B is a cover member detachably attached to the box main body 81A with a screw 101B. The segment 81B opens and closes an opening as a part of the housing member.

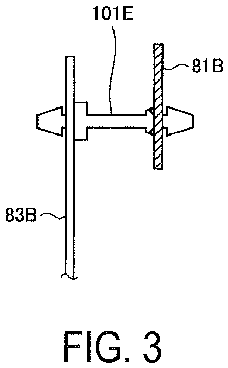

In the electrical circuit 83, a power device 83A is provided and connected to a circuit board 83B. The circuit board 83B is detachably attached to the segment 81B with a screw 101D via a spacer 101C inside the housing member as the box main body 81A. As illustrated in FIG. 3, the circuit board 83B may be detachably attached to the segment 81B with a locking support 101E.

In the segment 81B, a through-hole 81Ba is formed, which passes through the housing member as the box main body 81A. In the segment 81B, a refrigerant jacket 87 is detachably attached with a screw 101F so as to close the through-hole 81Ba. The power device 83A of the electrical circuit 83 is detachably attached to the refrigerant jacket 87 with a screw 101G via a heat transfer sheet 89 inside the housing member as the box main body 81A.

The refrigerant jacket 87 includes a refrigerant piping 87A inside which the refrigerant flows. The refrigerant piping 87A is provided so as to be sandwiched between a first heat transfer member 87B that is an aluminum block and a second heat transfer member 87C. The refrigerant piping 87A is, as illustrated in FIG. 1, connected in the outdoor unit 3, so as to bypass the liquid piping 37C and the intake piping 37E between the outdoor heat exchanger 19 and the indoor heat exchanger 47. A part of the liquid refrigerant from the liquid piping 37C flows through the refrigerant piping 87A. The first heat transfer member 87B and the second heat transfer member 87C are detachably attached with a screw 101H. The first heat transfer member 87B is detachably attached to the segment 81B with a screw 101F so as to close the through-hole 81Ba in the segment 81B. The power device 83A of the electrical circuit 83 is detachably attached with the screw 101G. To the periphery of the second heat transfer member 87C, a mounting piece 91 is detachably attached with a screw 1011. The mounting piece 91 is attached so as to extend to the outer circumference of the second heat transfer member 87C. The mounting piece 91 is detachably attached to the bracket 93 with a screw 101J. The bracket 93 is detachably attached to the base 85 with a screw 101K.

With such a configuration, in the refrigeration cycle device, the refrigerant that flows through the refrigerant piping 87A inside the refrigerant jacket 87 cools the power device 83A. This prevents a temperature of the power device 83A from exceeding a temperature at which the power device 83A is operable.

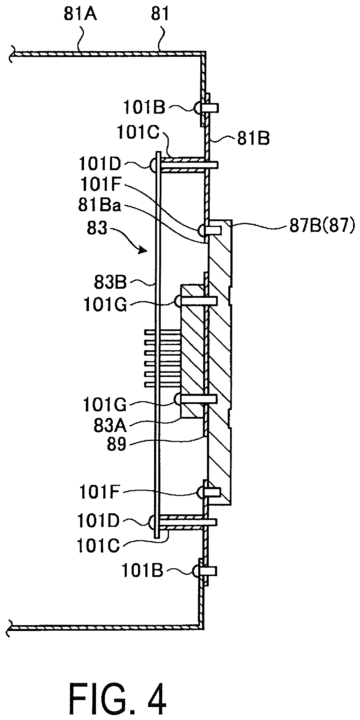

Referring to FIGS. 4 to 6, the following describes assembly of and disassembly for maintenance of the above-described configuration.

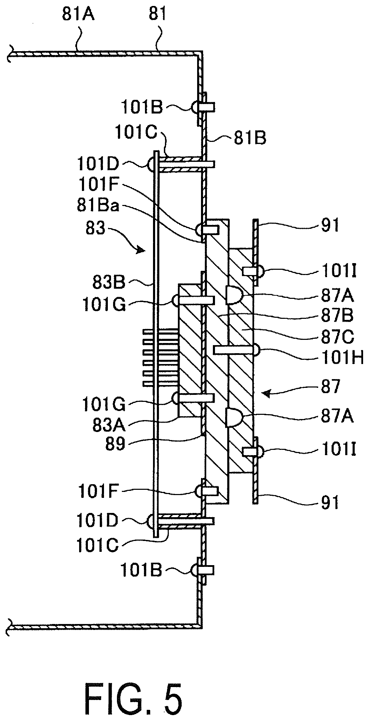

When assembling, as illustrated in FIG. 4, before the control box 81 is attached to the base 85, the electrical circuit 83 and the first heat transfer member 87B of the refrigerant jacket 87 is attached. Subsequently, as illustrated in FIG. 5, the refrigerant piping 87A and the second heat transfer member 87C are attached to the first heat transfer member 87B of the refrigerant jacket 87. And the mounting piece 91 is attached to the second heat transfer member 87C. The control box 81 with this configuration, as illustrated in FIG. 2, is attached to the base 85. The refrigerant jacket 87 with this configuration, as illustrated in FIG. 2, is thus attached to the bracket 93 that has been attached to the base 85.

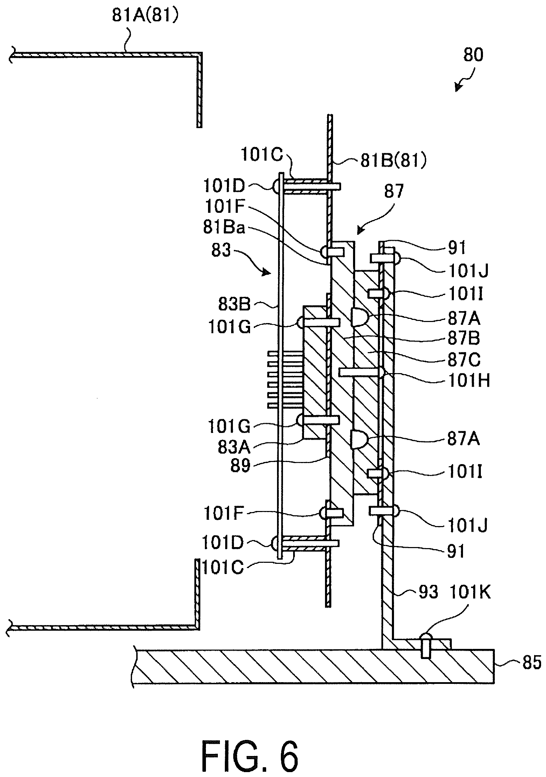

When disassembling for maintenance, as illustrated in FIG. 6, in the control box 81, the box main body 81A is removed from the segment 81B and the base 85. In the segment 81B, the circuit board 83B of the electrical circuit 83 has been attached and the refrigerant jacket 87 has been attached. That is, the electrical circuit 83 including the power device 83A is still attached to the bracket 93 via the segment 81B and the refrigerant jacket 87 and is still attached to the base 85. Therefore, the box main body 81A is taken out while leaving the refrigerant jacket 87 and the electrical circuit 83 on the base 85 side to perform maintenance for the components accommodated in the box main body 81A. The cable wired from the circuit board 83B of the electrical circuit 83, which is not illustrated, is connected to other circuit board, etc., via a connector in the box main body 81A. When removing the box main body 81A from the segment 81B and the base 85, the connector is disconnected, thereby detaching the electrical circuit 83 from the box main body 81A.

As illustrated in FIG. 2, the screw 101B that joins the box main body 81A and the segment 81B is disposed to be attached or removed from inside the box main body 81A. The screw 101I that joins the refrigerant jacket 87 and the bracket 93 is disposed to be attached or removed from the opposite side of the control box 81. The opposite side of the control box 81 is the back side, that is, the closed side for the outdoor unit 3 due to a wall, for example. The control box 81 side is the front side, that is, the open side for the outdoor unit 3. That is, when assembling, because the refrigeration cycle device is not yet installed, the assembly work can be achieved even on the back side of the outdoor unit 3. The refrigerant jacket 87 can thus be attached to the bracket 93 that has been attached to the base 85. On the other hand, when disassembling for maintenance, because the refrigeration cycle device has been installed, the disassembly work can hardly be achieved on the back side of the outdoor unit 3. The box main body 81A can thus be removed from the segment 81B on the control box 81 side. By disposing a device relatively hard to be damaged (an electrolytic condenser, for example) on the back side of the bracket 93, the opposite side of the control box 81 allows the device to be disposed outside the control box 81, thereby downsizing the control box 81.

As described above, the refrigeration cycle device according to the present embodiment includes the power device 83A provided on the circuit board 83B, the control box 81 to which the circuit board 83B is attached, the refrigerant jacket 87 that is provided outside the control box 81 and cools the power device 83 A by using refrigerant that flows inside the refrigerant jacket 87, the bracket 93 to which the refrigerant jacket 87 is attached, and the base 85 that independently secures the control box 81 and the bracket 93.

In the refrigeration cycle device, the refrigerant jacket 87 that cools the power device 83A is secured to the base 85 via the bracket 93, independently from the control box 81 to which the power device 83A is attached via the circuit board 83B. Therefore, when the refrigerant flows and the refrigerant jacket 87 is thus exited due to vibration transferred through the refrigerant piping 87A, the vibration of the refrigerant jacket 87 is absorbed by the bracket 93 independently from the control box 81. This reduces the transfer of the vibration to the power device 83A, independently from the strength of the control box 81, thereby reducing an act of a load on the power device 83A.

In the refrigeration cycle device according to the present embodiment, the circuit board 83B is detachably provided on the control box 81 side together with the refrigerant jacket 87, and is supported on the control box 81 side.

In the refrigeration cycle device, the circuit board 83B and the refrigerant jacket 87 are supported on the control box 81 side, whereby the refrigerant jacket 87 can be assembled in an integrated manner with the control box 81. When assembling, for example, the refrigerant piping 87A configured to allow the refrigerant to flow inside the refrigerant jacket 87 is not yet connected to any other place in the refrigeration cycle device. Therefore, assembling the refrigerant jacket 87 in an integrated manner with the control box 81 increases the assemblability.

In the refrigeration cycle device according to the present embodiment, the circuit board 83B is detachably provided on the bracket 93 side together with the refrigerant jacket 87, and is supported on the bracket 93 side.

In the refrigeration cycle device, the circuit board 83B and the refrigerant jacket 87 are supported on the bracket 93 side, whereby the control box 81 can be removed while leaving the circuit board 83B and the power device 83A together with the refrigerant jacket 87 on the bracket 93 side. When disassembling for maintenance, for example, the refrigerant piping 87A configured to allow the refrigerant to flow inside the refrigerant jacket 87 has been connected to any other place in the refrigeration cycle device. Therefore, removing the control box 81 while leaving and without removing the refrigerant jacket 87, the circuit board 83B, and the power device 83A cooled by the refrigerant jacket 87 increases the maintainability.

### Second Embodiment

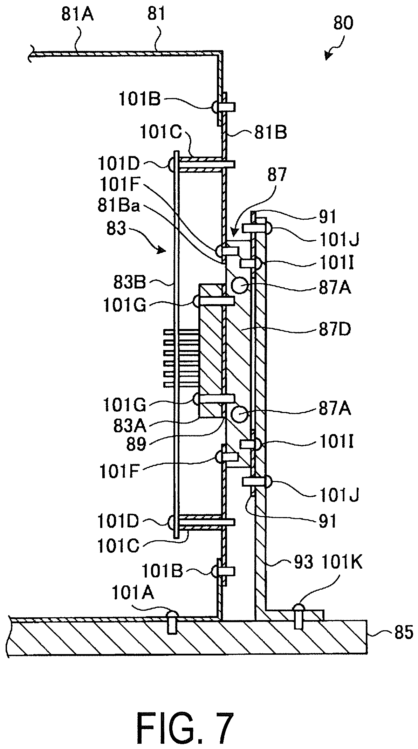

FIGS. 7 to 9 are enlarged views of a refrigeration cycle device according to the present embodiment.

As illustrated in FIG. 7, the cooling device 80 includes the control box 81 as a housing in which the electrical circuit 83 and other components are accommodated. The control box 81 includes a box main body 81A and a segment 81B. The box main body 81A is a housing member in which the electrical circuit 83 and other components are accommodated. The box main body 81A is detachably attached with a screw 101A to a base 85 that supports some of the above-described components of the outdoor unit 3. The segment 81B is a cover member detachably attached to the box main body 81A with a screw 101B. The segment 81B opens and closes an opening as a part of the housing member.

In the electrical circuit 83, a power device 83A is provided and connected to a circuit board 83B. The circuit board 83B is detachably attached to the segment 81B with a screw 101D via a spacer 101C inside the housing member as the box main body 81A. As illustrated in FIG. 3, the circuit board 83B may be detachably attached to the segment 81B with a locking support 101E.

In the segment 81B, a through-hole 81Ba is formed, which passes through the housing member as the box main body 81A. In the segment 81B, a refrigerant jacket 87 is detachably attached with a screw 101F so as to close the through-hole 81Ba. The power device 83A of the electrical circuit 83 is detachably attached to the refrigerant jacket 87 with a screw 101G via a heat transfer sheet 89 inside the housing member as the box main body 81A.

The refrigerant jacket 87 includes a refrigerant piping 87A inside which the refrigerant flows. The refrigerant piping 87A is provided so as to be inserted into the heat transfer member 87D that is an aluminum block. The refrigerant piping 87A is, as illustrated in FIG. 1, connected in the outdoor unit 3, so as to bypass the liquid piping 37C and the intake piping 37E between the outdoor heat exchanger 19 and the indoor heat exchanger 47. A part of the liquid refrigerant from the liquid piping 37C flows through the refrigerant piping 87A. The heat transfer member 87D is detachably attached to the segment 81B with the screw 101F so as to close the through-hole 81Ba in the segment 81B. The power device 83A of the electrical circuit 83 is detachably attached with the screw 101G. To the periphery of the heat transfer member 87D, the mounting piece 91 is detachably attached with the screw 1011. The mounting piece 91 is attached so as to extend to the outer circumference of the heat transfer member 87D. The mounting piece 91 is detachably attached to the bracket 93 with the screw 101J. The bracket 93 is detachably attached to the base 85 with a screw 101K.

With such a configuration, in the refrigeration cycle device, the refrigerant that flows through the refrigerant piping 87A inside the refrigerant jacket 87 cools the power device 83A. This prevents a temperature of the power device 83A from exceeding a temperature at which the power device 83A is operable.

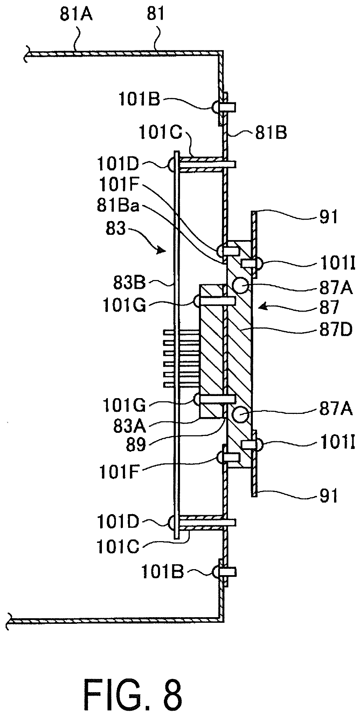

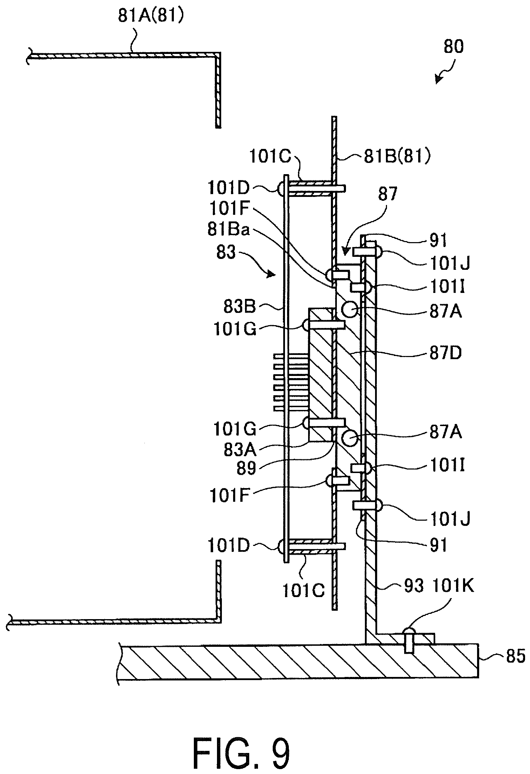

Referring to FIGS. 8 and 9, the following describes assembly of and disassembly for maintenance of the above-described configuration.

When assembling, as illustrated in FIG. 8, before the control box 81 is attached to the base 85, the electrical circuit 83 and the heat transfer member 87D of the refrigerant jacket 87 are attached. The mounting piece 91 is attached to the heat transfer member 87D of the refrigerant jacket 87. The control box 81 with this configuration is attached, as illustrated in FIG. 7, to the base 85. The refrigerant jacket 87 with this configuration is attached, as illustrated in FIG. 7, to the bracket 93 that has been attached to the base 85.

When disassembling for maintenance, as illustrated in FIG. 9, in the control box 81, the box main body 81A is removed from the segment 81B and the base 85. In the segment 81B, the circuit board 83B of the electrical circuit 83 has been attached and the refrigerant jacket 87 has been attached. That is, the electrical circuit 83 including the power device 83A is still attached to the bracket 93 via the segment 81B and the refrigerant jacket 87 and is still attached to the base 85. Therefore, the box main body 81A is taken out while leaving the refrigerant jacket 87 and the electrical circuit 83 on the base 85 side to perform maintenance for the components accommodated in the box main body 81A. The cable wired from the circuit board 83B of the electrical circuit 83, which is not illustrated, is connected to other circuit board, etc., via a connector in the box main body 81A. When removing the box main body 81A from the segment 81B and the base 85, the connector is disconnected, thereby detaching the electrical circuit 83 from the box main body 81A.

As illustrated in FIG. 7, the screw 101B that joins the box main body 81A and the segment 81B is disposed to be attached or removed from inside the box main body 81A. The screw 1011 that joins the refrigerant jacket 87 and the bracket 93 is disposed to be attached or removed from the opposite side of the control box 81. The opposite side of the control box 81 is the back side, the closed side for the outdoor unit 3 due to a wall, for example. The control box 81 side is the front side, the open side for the outdoor unit 3. That is, when assembling, because the refrigeration cycle device is not yet installed, the assembly work can be achieved even on the back side of the outdoor unit 3. The refrigerant jacket 87 can thus be attached to the bracket 93 that has been attached to the base 85. On the other hand, when disassembling for maintenance, because the refrigeration cycle device has been installed, the disassembly work can hardly be achieved on the back side of the outdoor unit 3. The box main body 81A can thus be removed from the segment 81B on the control box 81 side. Disposing a device relatively hard to be damaged (an electrolytic condenser, for example) onto the back side of the bracket 93, the opposite side of the control box 81 allows the device to be disposed outside the control box 81, thereby downsizing the control box 81.

As described above, the refrigeration cycle device according to the present embodiment includes the power device 83A provided on the circuit board 83B, the control box 81 to which the circuit board 83B is attached, the refrigerant jacket 87 that is provided outside the control box 81 and cools the power device 83A by using refrigerant that flows inside the refrigerant jacket 87, the bracket 93 to which the refrigerant jacket 87 is attached, and the base 85 that independently secures the control box 81 and the bracket 93.

In the refrigeration cycle device, the refrigerant jacket 87 that cools the power device 83A is secured to the base 85 via the bracket 93, independently from the control box 81 to which the power device 83A is attached via the circuit board 83B. Therefore, when the refrigerant flows and the refrigerant jacket 87 is thus exited due to vibration transferred through the refrigerant piping 87A, the vibration of the refrigerant jacket 87 is absorbed by the bracket 93, independently from the control box 81. This reduces the transfer of the vibration to the power device 83A, independently from the strength of the control box 81, thereby reducing an act of a load on the power device 83A.

In the refrigeration cycle device according to the present embodiment, the circuit board 83B is detachably provided on the control box 81 side together with the refrigerant jacket 87, and is supported on the control box 81 side.

In the refrigeration cycle device, the circuit board 83B and the refrigerant jacket 87 are supported on the control box 81 side, whereby the refrigerant jacket 87 can be assembled in an integrated manner with the control box 81. When assembling, for example, the refrigerant piping 87A configured to allow the refrigerant to flow inside the refrigerant jacket 87 is not yet connected to any other place in the refrigeration cycle device. Therefore, assembling the refrigerant jacket 87 in an integrated manner with the control box 81 increases the assemblability.

In the refrigeration cycle device according to the present embodiment, the circuit board 83B is detachably provided on the bracket 93 side together with the refrigerant jacket 87, and is supported on the bracket 93 side.

In the refrigeration cycle device, the circuit board 83B and the refrigerant jacket 87 are supported on the bracket 93 side, whereby the control box 81 can be removed while leaving the circuit board 83B and the power device 83A together with the refrigerant jacket 87 on the bracket 93 side. When disassembling for maintenance, for example, the refrigerant piping 87A configured to allow the refrigerant to flow inside the refrigerant jacket 87 has been connected to any other place in the refrigeration cycle device. Therefore, removing the control box 81 while leaving the circuit board 83B, and the power device 83A cooled by the refrigerant jacket 87 without removing the refrigerant jacket 87 increases the maintainability.

### Third Embodiment

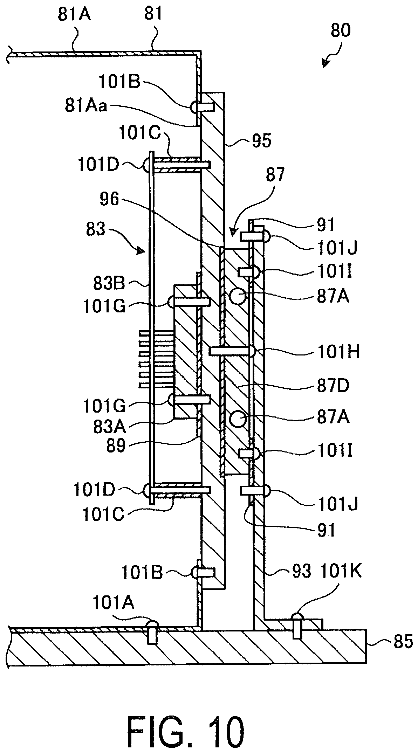

FIGS. 10 to 14 are enlarged views of a cooling device in a refrigeration cycle device according to the present embodiment.

As illustrated in FIG. 10, the cooling device 80 includes the control box 81 as a housing in which the electrical circuit 83 and other components are accommodated. The control box 81 includes the box main body 81A. The box main body 81A is a housing member in which the electrical circuit 83 and other components are accommodated. The box main body 81A is detachably attached with the screw 101A to the base 85 that supports some of the above-described components of the outdoor unit 3.

In the box main body 81A, a through-hole 81Aa is formed, which passes through the housing member. To the box main body 81A, the heat transfer plate 95 is detachably attached with the screw 101B so as to close the through-hole 81Aa. The heat transfer plate 95 is a heat transfer member including an aluminum block, and a cover member configured to open and close the through-hole 81Aa.

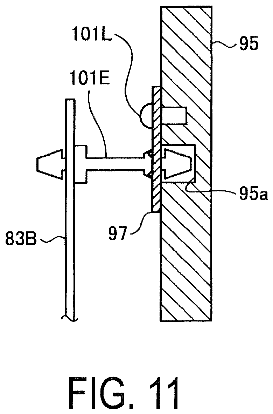

In the electrical circuit 83, the power device 83A is provided and connected to the circuit board 83B. The circuit board 83B is detachably attached to the heat transfer plate 95 with the screw 101D via the spacer 101C inside the housing member as the box main body 81A. As illustrated in FIG. 11, the circuit board 83B may be detachably attached with the locking support 101E to the support plate 97 detachably attached to the heat transfer plate 95 with a screw 101L so as to close a recessed portion 95a formed on the heat transfer plate 95. The power device 83A of the electrical circuit 83 is detachably attached to the heat transfer plate 95 with the screw 101G via the heat transfer sheet 89 inside the housing member as the box main body 81A.

The refrigerant jacket 87 includes the refrigerant piping 87A inside which the refrigerant flows. The refrigerant piping 87A is provided so as to be inserted into the heat transfer member 87D that is an aluminum block. The refrigerant piping 87A is, as illustrated in FIG. 1, connected in the outdoor unit 3, so as to bypass the liquid piping 37C and the intake piping 37E between the outdoor heat exchanger 19 and the indoor heat exchanger 47. A part of the liquid refrigerant from the liquid piping 37C flows through the refrigerant piping 87A. The heat transfer member 87D is detachably attached to the heat transfer plate 95 with the screw 101H via the heat transfer sheet 96 outside the housing member as the box main body 81A. To the periphery of the heat transfer member 87D, the mounting piece 91 is detachably attached with the screw 1011. The mounting piece 91 is attached so as to extend to the outer circumference of the heat transfer member 87D. The mounting piece 91 is detachably attached to the bracket 93 with the screw 101J. The bracket 93 is detachably attached to the base 85 with the screw 101K.

With such a configuration, in the refrigeration cycle device, the refrigerant that flows through the refrigerant piping 87A inside the refrigerant jacket 87 cools the power device 83A via the heat transfer plate 95. This prevents a temperature of the power device 83A from exceeding a temperature at which the power device 83A is operable.

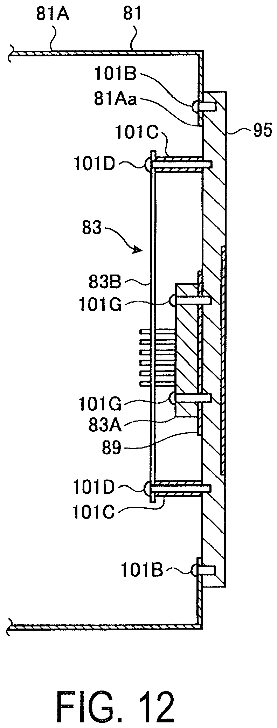

Referring to FIGS. 12 to 14, the following describes assembly of and disassembly for maintenance of the above-described configuration.

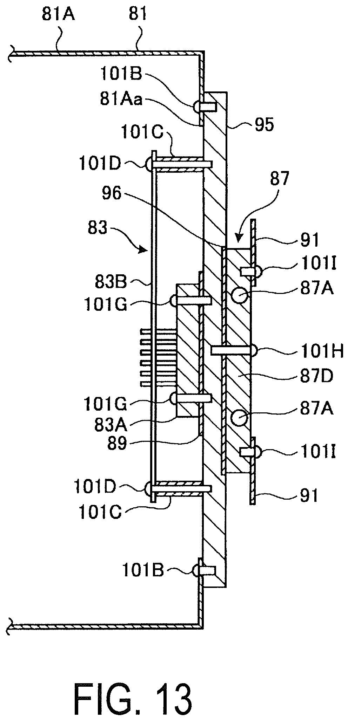

When assembling, as illustrated in FIG. 12, before the control box 81 is attached to the base 85, the electrical circuit 83 and the heat transfer plate 95 is attached. Subsequently, as illustrated in FIG. 13, the heat transfer member 87D of the refrigerant jacket 87 is attached to the heat transfer plate 95, and the mounting piece 91 is attached to the heat transfer member 87D. The control box 81 with this configuration is attached, as illustrated in FIG. 10, to the base 85. The refrigerant jacket 87 with this configuration is attached, as illustrated in FIG. 10, to the bracket 93 that has been attached to the base 85.

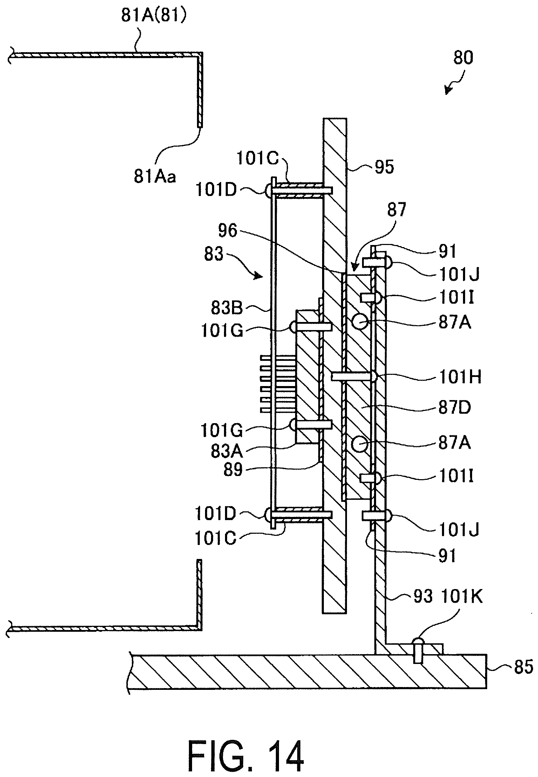

When disassembling for maintenance, as illustrated in FIG. 14, in the control box 81, the box main body 81A is removed from the heat transfer plate 95 and the base 85. In the heat transfer plate 95, the circuit board 83B of the electrical circuit 83 has been attached and the refrigerant jacket 87 has been attached. That is, the electrical circuit 83 including the power device 83A is still attached to the bracket 93 via the heat transfer plate 95 and the refrigerant jacket 87 and is still attached to the base 85. Therefore, the box main body 81A is taken out while leaving the refrigerant jacket 87 and the electrical circuit 83 on the base 85 side to perform maintenance for the components accommodated in the box main body 81A. The cable wired from the circuit board 83B of the electrical circuit 83, which is not illustrated, is connected to other circuit board, etc., via a connector in the box main body 81A. When removing the box main body 81A from the heat transfer plate 95 and the base 85, the connector is disconnected, thereby detaching the electrical circuit 83 from the box main body 81A.

As illustrated in FIG. 10, the screw 101B that joins the box main body 81A and the heat transfer plate 95 is disposed to be attached or removed from inside the box main body 81A. The screw 101I that joins the refrigerant jacket 87 and the bracket 93 is disposed to be attached or removed from the opposite side of the control box 81. The opposite side of the control box 81 is the back side, that is, the closed side for the outdoor unit 3 due to a wall, for example. The control box 81 side is the front side, that is, the open side for the outdoor unit 3. That is, when assembling, because the refrigeration cycle device is not yet installed, the assembly work can be achieved even on the back side of the outdoor unit 3. The refrigerant jacket 87 can thus be attached to the bracket 93 that has been attached to the base 85. On the other hand, when disassembling for maintenance, because the refrigeration cycle device has been installed, the disassembly work can hardly be achieved on the back side of the outdoor unit 3. The box main body 81A can thus be removed from the heat transfer plate 95 on the control box 81 side. Disposing a device relatively hard to be damaged (an electrolytic condenser, for example) onto the back side of the bracket 93, the opposite side of the control box 81 allows the device to be disposed outside the control box 81, thereby downsizing the control box 81.

As described above, the refrigeration cycle device according to the present embodiment includes the power device 83A provided on the circuit board 83B, the control box 81 to which the circuit board 83B is attached, the refrigerant jacket 87 that is provided outside the control box 81 and cools the power device 83A by using refrigerant that flows inside the refrigerant jacket 87, the bracket 93 to which the refrigerant jacket 87 is attached, and the base 85 that independently secures the control box 81 and the bracket 93.

In the refrigeration cycle device, the refrigerant jacket 87 that cools the power device 83A is secured to the base 85 via the bracket 93, independently from the control box 81 to which the power device 83A is attached via the circuit board 83B. Therefore, when the refrigerant flows and the refrigerant jacket 87 is thus exited due to vibration transferred through the refrigerant piping 87A, the vibration of the refrigerant jacket 87 is absorbed by the bracket 93, independently from the control box 81. This reduces the transfer of the vibration to the power device 83A, thereby further reducing an act of a load on the power device 83A.

In the refrigeration cycle device according to the present embodiment, the refrigerant jacket 87 and the power device 83A are attached to each other via the heat transfer plate 95.

In the refrigeration cycle device, the refrigerant jacket 87 and the power device 83A are attached via the heat transfer plate 95. Therefore, when the refrigerant flows and the refrigerant jacket 87 is thus exited due to vibration transferred through the refrigerant piping 87A, the vibration of the refrigerant jacket 87 is absorbed by the heat transfer plate 95. This reduces the transfer of the vibration to the power device 83A, independently from the strength of the control box 81, thereby further reducing an act of a load on the power device 83A.

In the refrigeration cycle device according to the present embodiment, the circuit board 83B is attached to the control box 81 via the heat transfer plate 95.

In the refrigeration cycle device, the circuit board 83B is attached to the heat transfer plate 95. Therefore, when the refrigerant flows and the refrigerant jacket 87 is thus exited due to vibration transferred through the refrigerant piping 87A, the vibration of the refrigerant jacket 87 is absorbed by the heat transfer plate 95 and transferred to not only the power device 83A but also the circuit board 83B. As a result, an identical vibration is transferred to the power device 83A and the circuit board 83B, thereby preventing the connection between the power device 83A and the circuit board 83B from being disconnected.

In the refrigeration cycle device according to the present embodiment, the circuit board 83B is detachably provided on the control box 81 side together with the refrigerant jacket 87 via the heat transfer plate 95, and is supported on the control box 81 side.

In the refrigeration cycle device, the circuit board 83B, the heat transfer plate 95, and the refrigerant jacket 87 are supported on the control box 81 side, whereby the refrigerant jacket 87 can be assembled in an integrated manner with the control box 81. When assembling, for example, the refrigerant piping 87A configured to allow the refrigerant to flow inside the refrigerant jacket 87 is not yet connected to any other place in the refrigeration cycle device. Therefore, assembling the refrigerant jacket 87 in an integrated manner with the control box 81 increases the assemblability.

In the refrigeration cycle device according to the present embodiment, the circuit board 83B is detachably provided on the bracket 93 side together with the refrigerant jacket 87 via the heat transfer plate 95, and is supported on the bracket 93 side.

In the refrigeration cycle device, the circuit board 83B, the heat transfer plate 95, and the refrigerant jacket 87 are supported on the bracket 93 side, whereby the control box 81 can be removed while leaving the circuit board 83B and the power device 83A together with the refrigerant jacket 87 on the bracket 93 side. When disassembling for maintenance, for example, the refrigerant piping 87A configured to allow the refrigerant to flow inside the refrigerant jacket 87 has been connected to any other place in the refrigeration cycle device. Therefore, removing the control box 81 while leaving and without removing the refrigerant jacket 87, the circuit board 83B, and the power device 83A cooled by the refrigerant jacket 87 increases the maintainability.

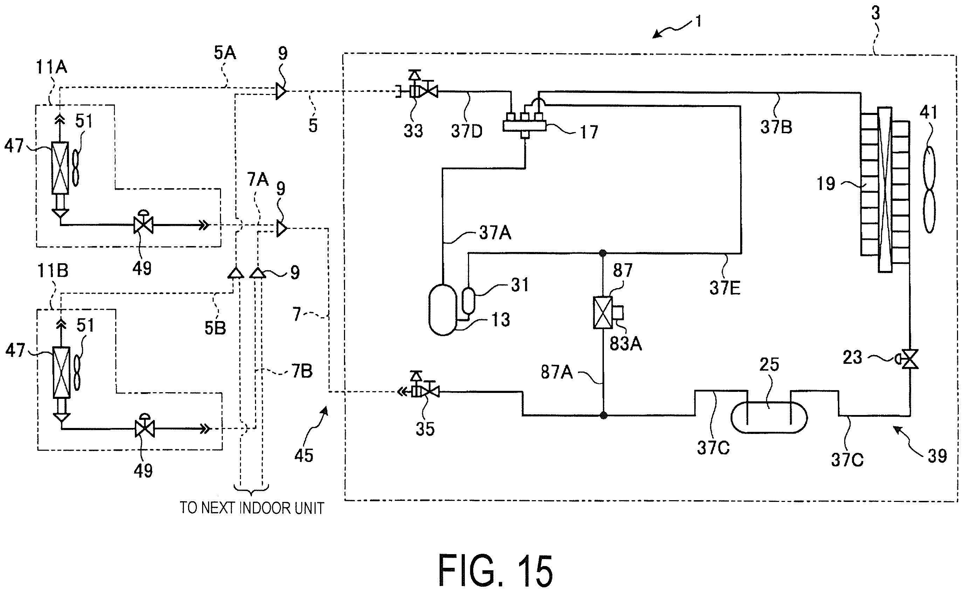

FIG. 15 is another example refrigerant circuit diagram of a refrigeration cycle device according to the present embodiment. The refrigeration cycle device illustrated in FIG. 1 includes a subcooling circuit including the subcooling heat exchanger 27, the electronic expansion valve for subcooling 29, and the branching piping for subcooling 37F. In the refrigeration cycle device illustrated in FIG. 1, the refrigerant piping 87A is connected to the liquid piping 37C at a position nearer to the liquid-side operation valve 35 than the position at which the branching piping for subcooling 37F is connected. The refrigeration cycle device illustrated in FIG. 15 does not include the subcooling circuit including the subcooling heat exchanger 27, the electronic expansion valve for subcooling 29, and the branching piping for subcooling 37F. The liquid piping 37C is connected regardless of the subcooling circuit.

### Reference Numerals

81 Control box
83A Power device
83B Circuit board
85 Base
87 Refrigerant jacket
93 Bracket
95 Heat transfer plate

## Claims

1. A refrigeration cycle device comprising:
a power device provided on a circuit board;
a control box to which the circuit board is attached;
a refrigerant jacket provided outside the control box and configured to cool the power device by using refrigerant flowing inside the refrigerant jacket;
a bracket to which the refrigerant jacket is attached; and
a base configured to independently secure the control box and the bracket.

2. The refrigeration cycle device according to claim 1, wherein the circuit board is detachably provided on the control box side together with the refrigerant jacket, and is supported on the control box side.

3. The refrigeration cycle device according to claim 1, wherein the circuit board is detachably provided on the bracket side together with the refrigerant jacket, and is supported on the bracket side.

4. The refrigeration cycle device according to claim 1, wherein the refrigerant jacket and the power device are attached to each other via a heat transfer plate.

5. The refrigeration cycle device according to claim 4, wherein the circuit board is attached to the control box via the heat transfer plate.

6. The refrigeration cycle device according to claim 4 or 5, wherein the circuit board is detachably provided on the control box side together with the refrigerant jacket via the heat transfer plate, and is supported on the control box side.

7. The refrigeration cycle device according to claim 4 or 5, wherein the circuit board is detachably provided on the bracket side together with the refrigerant jacket via the heat transfer plate, and is supported on the bracket side.

## Amended claims

### Amended claims under Art. 19.1 PCT

**1.** [Amended]
A refrigeration cycle device comprising:
a power device provided on a circuit board;
a control box to which the circuit board is attached;
a refrigerant jacket provided outside the control box and configured to cool the power device by using refrigerant flowing inside the refrigerant jacket;
a bracket to which the refrigerant jacket is attached; and
a base configured to secure the control box and the bracket independently and support each component of an outdoor unit.

**2.** The refrigeration cycle device according to claim 1, wherein the circuit board is detachably provided on the control box side together with the refrigerant jacket, and is supported on the control box side.

**3.** The refrigeration cycle device according to claim 1, wherein the circuit board is detachably provided on the bracket side together with the refrigerant jacket, and is supported on the bracket side.

**4.** The refrigeration cycle device according to claim 1, wherein the refrigerant jacket and the power device are attached to each other via a heat transfer plate.

**5.** The refrigeration cycle device according to claim 4, wherein the circuit board is attached to the control box via the heat transfer plate.

**6.** The refrigeration cycle device according to claim 4 or 5, wherein the circuit board is detachably provided on the control box side together with the refrigerant jacket via the heat transfer plate, and is supported on the control box side.

**7.** The refrigeration cycle device according to claim 4 or 5, wherein the circuit board is detachably provided on the bracket side together with the refrigerant jacket via the heat transfer plate, and is supported on the bracket side.

**8.** [New]
A refrigeration cycle device comprising:
a power device provided on a circuit board;
a control box to which the circuit board is attached;
a refrigerant jacket provided outside the control box and configured to cool the power device by using refrigerant flowing inside the refrigerant jacket;
a bracket to which the refrigerant jacket is attached; and
a base configured to independently secure the control box and the bracket, wherein
the circuit board is detachably provided on the bracket side together with the refrigerant jacket, and is supported on the bracket side.

**9.** [New]
A refrigeration cycle device comprising:
a power device provided on a circuit board;
a control box to which the circuit board is attached;
a refrigerant jacket provided outside the control box and configured to cool the power device by using refrigerant flowing inside the refrigerant jacket;
a bracket to which the refrigerant jacket is attached; and
a base configured to independently secure the control box and the bracket, wherein
the refrigerant jacket and the power device are attached to each other via a heat transfer plate, and
the circuit board is detachably provided on the bracket side together with the refrigerant jacket via the heat transfer plate, and is supported on the bracket side.

Statement under Art. 19.1 PCT
Claim 1 in Scope of Claims is corrected by adding "a base configured to secure the control box and the bracket independently and support each component of an outdoor unit" according to the paragraph [0041] in the initial application specification.

Claim 8 in Scope of Claims is added according to claims 1 and 3.

Claim 9 in Scope of Claims is added according to claims 1, 4, and 7.
